# EUROPEAN PATENT APPLICATION

(11) **EP 4 456 103 A1**
(43) Date of publication of application: **30.10.2024**
(21) Application number: 22910959.0
(22) Date of filing: 09.12.2022
(51) Int. Cl.: H01H 3/12, H01H 13/14

(54) **ELECTRONIC APPARATUS**

(30) Priority: 21.12.2021 JP 2021207090
(71) Applicant: Casio Computer Co., Ltd., Tokyo 151-8543 (JP)
(72) Inventor: EGUCHI Hiroki, Hamura-shi, Tokyo 205-8555 (JP)
(74) Representative: Grünecker Patent- und Rechtsanwälte PartG mbB
(86) International application number: PCT/JP2022/045512
(87) International publication number: WO 2023/120249

(57) **Abstract**

Provided is an electronic apparatus capable of facilitating a pushdown operation of an operation button. The electronic apparatus (100) comprises: an operation button (212) having a flange (212b); and an apparatus case (1) having formed therein an opening (1C) into which the operation button (212) is inserted. The apparatus case (1) is provided with a guide rib (1A2) which guides the reception of the flange (212b) into a region (R). At least a portion of the guide rib (1A2) is configured so that when the operation button (212) is pushed in the pushdown direction, the gap between the flange (212b) and the guide rib (1A2) expands.

## Description

### TECHNICAL FIELD

The present invention relates to an electronic device.

### BACKGROUND ART

In the related art, an electronic desktop computer (calculator) is widely used for simple calculation. In particular, in the electronic desktop computer, a key arrangement is determined and a key touch is devised so that a quick and accurate input operation can be performed in office applications such as performing a large number of calculations (see, for example, Patent Literature 1).

### CITATION LIST

### PATENT LITERATURE

Patent Literature 1: JPS61-190630U

### SUMMARY OF INVENTION

### TECHNICAL PROBLEM

However, in a key structure disclosed in Patent Literature 1, for example, when a side surface 1B of a keytop portion 1 is pressed to be in a so-called obliquely pressed state, a stem portion 2 interferes with a panel 3, and a failure in which a keytop portion 1 is not fully pressed may occur.

The present invention has been made in view of the above circumstances, and an object thereof is to smoothly perform a pressing operation of an operation button.

### SOLUTION TO PROBLEM

In order to achieve the above object, an electronic device according to the present invention includes:
an operation button having a flange; and
a device case formed with an opening into which the operation button is inserted, in which
the device case is provided with a guide rib that guides reception of the flange into a region, and
at least a part of the guide rib is configured such that an interval between the flange and the guide rib is widened when a pressing operation is performed toward a pressing direction of the operation button.

### ADVANTAGEOUS EFFECTS OF INVENTION

According to the present invention, a pressing operation of an operation button can be smoothly performed.

### BRIEF DESCRIPTION OF DRAWINGS

[FIG. 1] FIG. 1 is a perspective view showing an overview of a scientific electronic calculator as an example of an electronic device.
[FIG. 2] FIG. 2 is a block diagram showing a functional configuration of a scientific electronic calculator.
[FIG. 3] FIG. 3 is a schematic view showing a structure of a key.
[FIG. 4] FIG. 4 is a view showing an aspect in which an operation button is inserted into an opening of an upper case (device case).
[FIG. 5A] FIG. 5A is a view showing a state where an operation button is inserted into the opening of the upper case in a correct orientation.
[FIG. 5B] FIG. 5B is a view showing a state where an operation button is to be inserted into the opening of the upper case in a wrong orientation.
[FIG. 5C] FIG. 5C is a view showing a state where an operation button inserted into the opening of the upper case is rotated in a clockwise direction in the drawing.
[FIG. 6A] FIG. 6A is an enlarged view of an upper left corner of FIG. 5A.
[FIG. 6B] FIG. 6B is an enlarged view of a lower left corner of FIG. 5A.
[FIG. 7A] FIG. 7A is a view showing a state where an operation button is to be inserted into the opening of the upper case in a wrong orientation.
[FIG. 7B] FIG. 7B is a view showing a state where an operation button is to be inserted into the opening of the upper case in a wrong orientation.
[FIG. 7C] FIG. 7C is a view showing a state where an operation button is to be inserted into the opening of the upper case in a wrong orientation.
[FIG. 7D] FIG. 7D is a view showing a state where an operation button is to be inserted into the opening of the upper case in a wrong orientation.
[FIG. 7E] FIG. 7E is a view showing a state where an operation button is to be inserted into the opening of the upper case in a wrong orientation.
[FIG. 8A] FIG. 8A is a view showing a state where an operation button is to be inserted into the opening of the upper case in a wrong orientation.
[FIG. 8B] FIG. 8B is a view showing a state where an operation button is to be inserted into the opening of the upper case in a wrong orientation.
[FIG. 8C] FIG. 8C is a view showing a state where an operation button is to be inserted into the opening of the upper case in a wrong orientation.
[FIG. 8D] FIG. 8D is a view showing a state where an operation button is to be inserted into the opening of the upper case in a wrong orientation.
[FIG. 8E] FIG. 8E is a view showing a state where an operation button is to be inserted into the opening of the upper case in a wrong orientation.
[FIG. 9A] FIG. 9A is a view illustrating a guide rib of the related art.
[FIG. 9B] FIG. 9B is a view showing a state of an operation button when a pressing operation of an end of the operation button is performed in a case where the guide rib of the related art is provided.
[FIG. 9C] FIG. 9C is a view showing a state of an operation button when a pressing operation of an end of the operation button is performed in a case where a guide rib according to the present embodiment is provided.
[FIG. 10A] FIG. 10A is a view showing measurement points of various dimensions for a flange and a guide rib.
[FIG. 10B] FIG. 10B is a table showing the correspondence of the various dimensions between a key group of type I and a key group of type II.

### DESCRIPTION OF EMBODIMENTS

Hereinafter, an embodiment of an electronic device according to the present invention will be described with reference to the drawings. Hereinafter, a case where the electronic device is a scientific electronic calculator will be described, but the present invention is not limited to a case where the electronic device is a scientific electronic calculator, and is applied to any electronic device as long as the electronic device is an electronic device including an operation button that is inserted into an opening of a device case so as to be pressed.

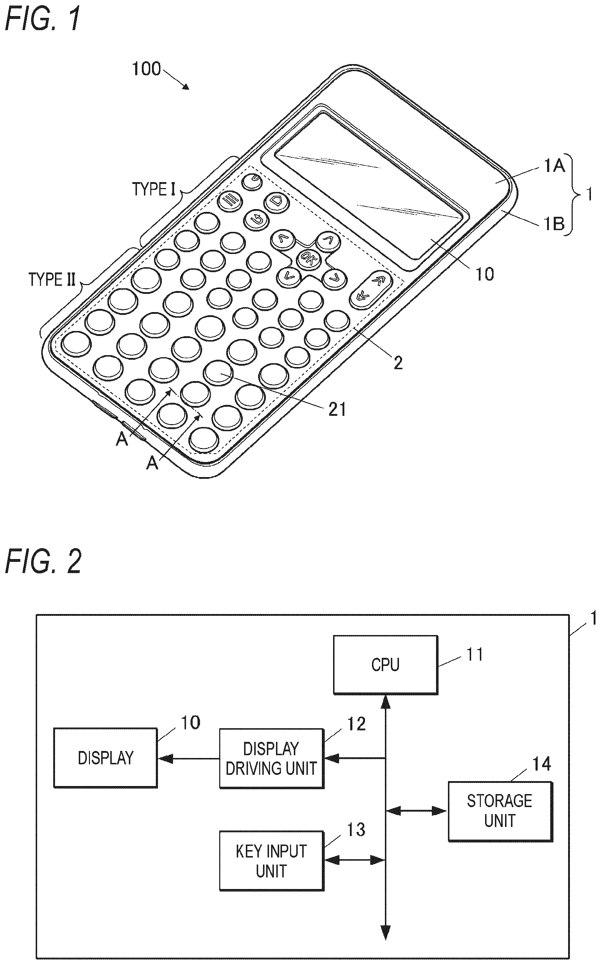

FIG. 1 is a perspective view of a scientific electronic calculator as an example of an electronic device according to the present embodiment. As shown in FIG. 1, a scientific electronic calculator 100 includes a display 10 and an input key group 2 including various key groups.

The input key group 2 is a key group for receiving an input operation of a mathematical expression component such as a numerical value, a calculation symbol, or the like from a user or receiving instruction operations of various processes, and includes a plurality of keys (a numeric key, a cursor key, an AC key, a CODE key, a SHIFT key, and the like) to which specific functions are assigned.

The display 10 is, for example, a liquid crystal display (LCD), and is a display unit that displays various data such as characters, codes, symbols, mathematical expressions, calculation results, and tables (referred to as mathematical expressions, tables, and the like) corresponding to operations of the input key group 2 and the like on a plurality of dots.

### [Functional Configuration]

Next, a functional configuration of the scientific electronic calculator 100 will be described. FIG. 2 is a block diagram showing the functional configuration of the scientific electronic calculator 100. As shown in FIG. 2, the scientific electronic calculator 100 includes a central processing unit (CPU) 11, a display driving unit 12, a key input unit 13, and a storage unit 14. Although not shown, the scientific electronic calculator 100 appropriately includes, for example, a random access memory (RAM) that temporarily stores data such as mathematical expressions and tables displayed on the display 10.

The display driving unit 12 performs driving control to display various kinds of information on the display 10 under the control of the CPU 11. The display driving unit 12 adjusts a contrast ratio when displaying on the display 10.

The key input unit 13 includes the above-described input key group 2, and outputs, to the CPU 11, a key input signal corresponding to a key input by a user operation. Then, the CPU 11 receives a key input signal corresponding to a key input by a user operation, displays a corresponding mathematical expression, table, or the like on the display 10, executes calculation, or performs various processes.

The storage unit 14 is a memory that stores programs and the like. In the present embodiment, the storage unit 14 includes various storage areas, and includes a storage area for storing programs for the CPU 11 to execute various functions of the scientific electronic calculator 100 and data necessary for executing the programs.

The CPU 11 centrally controls each unit of the scientific electronic calculator 100. Specifically, the CPU 11 reads a program specified from the system program and the various application programs stored in the storage area of the storage unit 14, develops the program in the work area of the storage unit 14, and executes various processes in cooperation with the program developed in the storage unit 14. The CPU 11 controls the display driving unit 12 to perform necessary display on the display 10.

### [Key Structure]

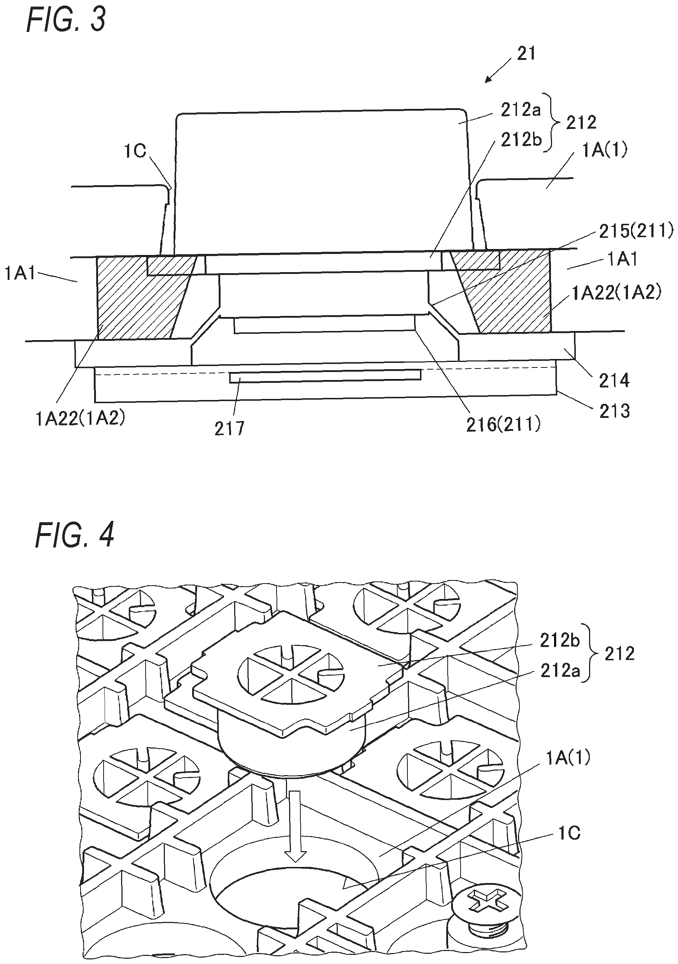

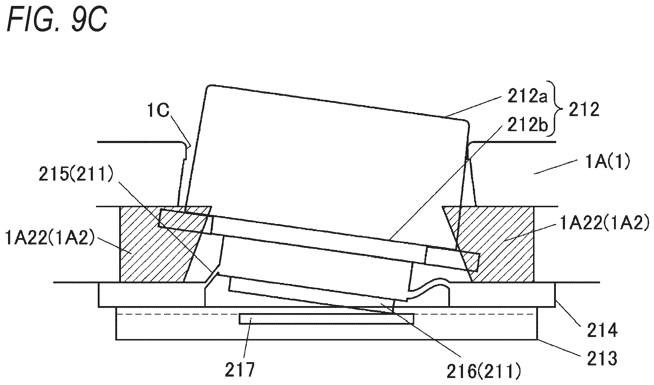

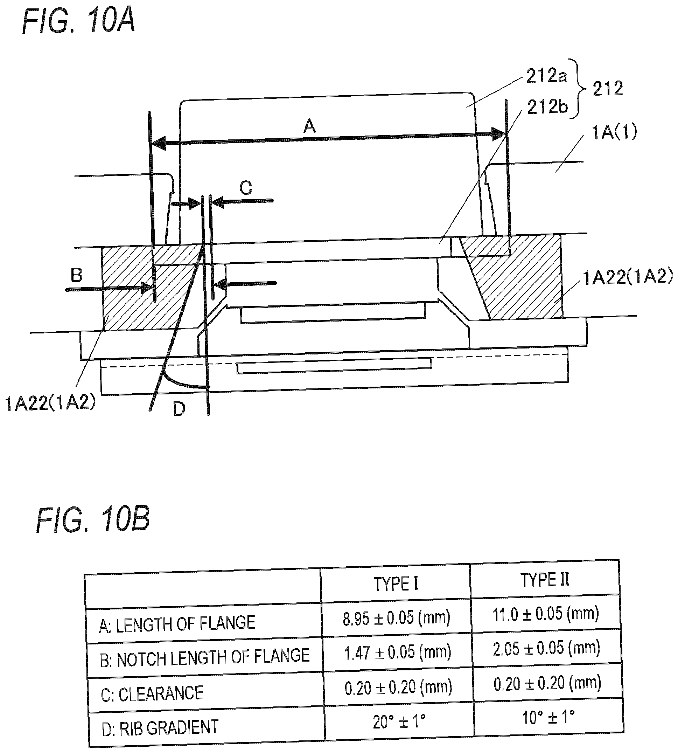

Next, a structure of each of the keys constituting the input key group 2 will be described by using, as a representative example, a key 21 shown in FIG. 1. FIG. 3 is a schematic view showing a structure of the key 21. FIG. 3 (similarly to FIG. 9C and FIG. 10A) shows a cross-section of a pair of second protruding pieces 1A22 in order to show a relation between a flange 212b (to be described later) and the pair of second protruding pieces 1A22 (to be described later). The cross-section is a cross-section taken along a line A-A of FIG. 1.

As shown in FIG. 3, the key 21 includes an operation button 212 and a key contact member 211. The key contact member 211 is disposed in a device case 1 including an upper case 1A and a lower case 1B. The operation button 212 is provided on the key contact member 211, and an upper portion of the operation button 212 protrudes upward from an opening 1C of the device case 1 and is exposed. The key contact member 211 includes a dome-shaped bulging portion 215 and a movable contact 216 provided inside the bulging portion 215. The bulging portion 215 is connected to a rubber sheet 214 disposed on a circuit board 213 provided below the upper case 1A. In the present embodiment, the bulging portion 215 and the rubber sheet 214 are integrally formed. The key contact member 211 is configured to correspond to a plurality of openings 1C (only one opening 1C is shown in FIG. 3) provided in the device case 1. The bulging portion 215 is connected to a lower portion of the operation button 212 by, for example, a method such as press fitting. The movable contact 216 is made of, for example, carbon.

A fixed contact 217 is provided to face the movable contact 216 on an upper surface of the circuit board 213 so as to be able to come into contact with or separate from the movable contact 216. Accordingly, the key contact member 211 is configured such that when the bulging portion 215 is pressed down by the operation button 212, the bulging portion 215 is elastically deformed and the movable contact 216 comes into contact (makeup) with the fixed contact 217 (see FIG. 9C), thereby outputting a key input signal.

As shown in FIGS. 3 and 4, the operation button 212 is a synthetic resin member including a main body 212a and a flange 212b extending radially outward at a lower end of the main body 212a. In the present embodiment, the main body 212a has a cylindrical shape, but a shape of the main body 212a is not limited thereto. Here, FIG. 4 is a view showing an aspect in which the operation button 212 is inserted into the opening 1C of the upper case 1A (the device case 1).

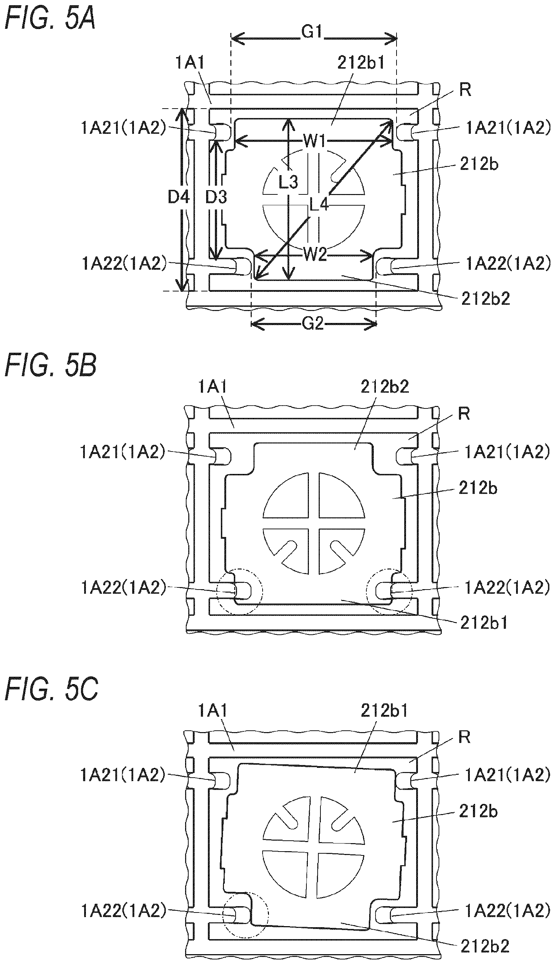

As shown in FIGS. 4, 5A, 5B, and 5C, the flange 212b has a generally rectangular shape in plan view, and is formed larger than an area of the opening 1C. Accordingly, as shown in FIG. 3, an upper surface of the flange 212b (a surface on a main body 212a side) comes into contact with a lower surface of an edge portion in the opening 1C of the upper case 1A (a surface facing the rubber sheet 214) so that the flange 212b does not come out of the opening 1C.

Next, a shape of the flange 212b will be described in detail with reference to FIGS. 5A, 5B, and 5C. FIG. 5A is a view showing a state where the operation button 212 is inserted into the opening 1C of the upper case 1A in a correct orientation (an orientation). FIG. 5B is a view showing a state where the operation button 212 is to be inserted into the opening 1C of the upper case 1A in a wrong orientation (an orientation other than the above-described orientation). FIG. 5C is a view showing a state where the operation button 212 inserted into the opening 1C of the upper case 1A is rotated in a clockwise direction on the sheet.

As shown in FIG. 5A, the flange 212b of the operation button 212 has a substantially rectangular shape in plan view as described above, and each corner of the lower left and the lower right is cut out. Therefore, a width W1 in a left-right direction of an extension portion (a first extension portion) 212b1 of the flange 212b extending upward on the sheet is larger than a width W2 in the left-right direction of an extension portion (a second extension portion) 212b2 extending downward on the sheet.

On the other hand, as shown in FIG. 5A, a lower surface of the upper case 1A is provided with a frame portion 1A1 that defines a region R (a region) for receiving the flange 212b. Here, the frame portion 1A1 serves as a spacer for providing the key contact member 211 (see FIG. 3) with a predetermined interval from the flange 212b. The lower surface of the upper case 1A is provided with a guide rib 1A2 that guides the reception of the flange 212b into the region R. The guide rib 1A2 is connected to the frame portion 1A1. In the present embodiment, the guide rib 1A2 and the frame portion 1A1 are integrally formed.

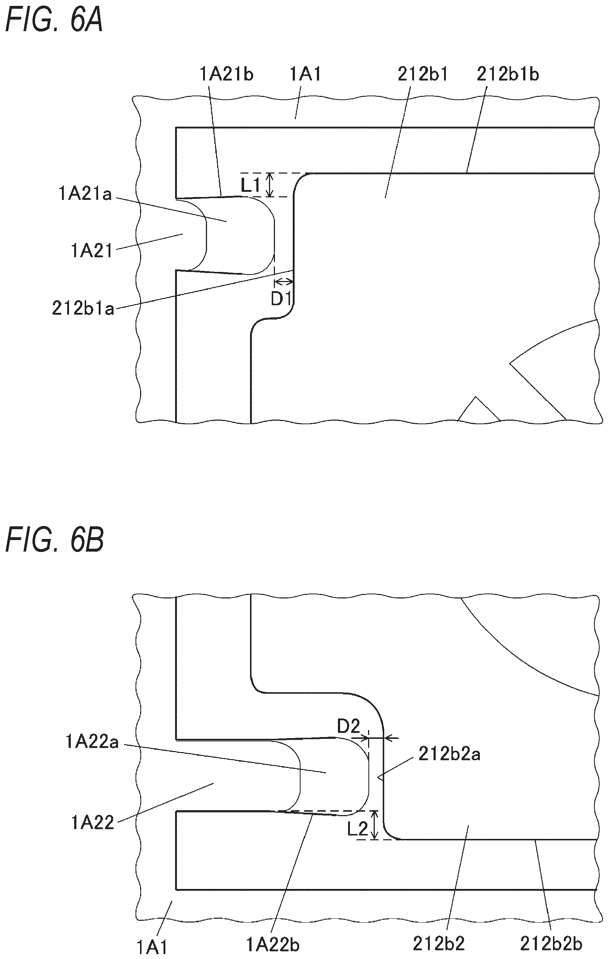

As shown in FIG. 5A, the guide rib 1A2 includes a pair of first protruding pieces 1A21 provided at an upper left corner and an upper right corner of the region R, and a pair of second protruding pieces 1A22 provided at a lower left corner and a lower right corner of the region R. The pair of first protruding pieces 1A21 are provided at an interval wider than the width W1 of a first extension portion 212b1, and when the flange 212b is received in the region R, the first protruding pieces 1A21 sandwich the first extension portion 212b1 from lateral sides. In addition, the pair of second protruding pieces 1A22 are provided at an interval wider than the width W2 of a second extension portion 212b2 and narrower than the width W1 of the first extension portion 212b1, and when the flange 212b is received in the region R, the second protruding pieces 1A22 sandwich the second extension portion 212b2 from lateral sides. In other words, an interval G1 between a pair of outer surfaces 1A21a (see FIG. 6A) facing each other of the pair of first protruding pieces 1A21 is larger than the width W1, and an interval G2 between a pair of outer surfaces 1A22a (see FIG. 6B) facing each other of the pair of second protruding pieces 1A22 is larger than the width W2 and smaller than the width W1. In FIG. 5A, although the intervals G1 and G2 are shown at base ends of the outer surfaces 1A21a and 1A22a, the interval G1 is larger than the width W1 and the interval G2 is larger than the width W2 and smaller than the width W1 at any position of the pair of outer surfaces 1A21a and 1A22a.

A length L3 of the flange 212b in an extending direction (a direction orthogonal to the widths W1 and W2) is longer than a distance D3 between the first protruding piece 1A21 and the second protruding piece 1A22 and longer than the interval G2. A length L4 of a diagonal line of the flange 212b (a straight line passing through a corner portion of the first extension portion 212b1 and a corner portion of the second extension portion 212b2 facing the corner portion of the first extension portion 212b1) is longer than a width D4 of the region R in an up-down direction (an extending direction of the flange 212b). When the operation button 212 is to be inserted into the opening 1C of the upper case 1A in a wrong orientation (A predetermined orientation other than the correct orientation. For example, an angle of 10 degrees or more and less than 90 degrees, an angle of more than 90 degrees and 170 degrees or less, an angle of 190 degrees or more and less than 270 degrees, or an angle of more than 270 degrees and less than 350 degrees in a clockwise direction with reference to the correct orientation), the first extension portion 212b1 of the flange 212b is designed to have a length that engages (overlaps) with the frame portion 1A1.

More specifically, the opening 1C is formed such that, when the operation button 212 is to be inserted into the opening 1C in a vertically reversed orientation on the sheet of FIG. 5A (that is, when viewed from an insertion direction, the main body 212a is positioned inside the opening 1C and the operation button 212 faces an opposite side to the correct orientation), a part of the extension portion 212b1 overlaps the second protruding piece 1A22. In the present embodiment, the opening 1C is positioned at the center of the region R.

Accordingly, when the operation button 212 is to be inserted into the opening 1C of the upper case 1A in a wrong orientation (for example, a vertically reversed orientation), as shown in FIG. 5B, the first extension portion 212b1 of the flange 212b engages with the pair of second protruding pieces 1A22 (the first extension portion 212b1 of the flange 212b overlaps the second protruding piece 1A22), so that the operation button 212 can be prevented from being inserted (completely inserted) into the opening 1C. In the present specification, "completely inserted" means that the operation button 212 is inserted to such an extent that the operation button 212 can be used as a product, and does not include a state where only a tip end portion of the main body 212a is positioned inside the opening 1C in the process of insertion. On the other hand, as shown in FIG. 5A, when the operation button 212 is inserted into the opening 1C of the upper case 1A in a correct orientation, the flange 212b does not engage with (does not overlap) the guide rib 1A2.

In the present embodiment, the first protruding piece 1A21 is disposed close to the first extension portion 212b1, and the second protruding piece 1A22 is disposed close to the second extension portion 212b2. When the operation button 212 correctly inserted into the opening 1C of the upper case 1A is rotated to an angle, as shown in FIG. 5C, the flange 212b engages with the guide rib 1A2 (engages with each other in a rotation direction), so that the flange 212b can be prevented from rotating beyond the above angle. In the present embodiment, when the second extension portion 212b2 of the flange 212b engages with the pair of second protruding pieces 1A22 (engages with each other in the rotation direction), the flange 212b can be prevented from rotating beyond the above angle. In addition, depending on a clearance between the main body 212a and the opening 1C and a manufacturing error, the first extension portion 212b1 of the flange 212b may be engaged with the first protruding piece 1A21. Accordingly, the flange 212b can also be prevented from rotating beyond the above angle.

Specifically, as shown in FIG. 6A, in a state where the operation button 212 is inserted in a correct orientation, a length L1 from an outer surface (a surface facing the frame portion 1A1) 1A21b of the first protruding piece 1A21 to a side surface (a surface facing the frame portion 1A1) 212b1b of the first extension portion 212b1 in an extending direction is longer than a distance D1 between a side surface (a surface facing the first protruding piece 1A21) 212b1a of the first extension portion 212b1 and the outer surface 1A21a. Similarly, as shown in FIG. 6B, in a state where the operation button 212 is inserted in a correct orientation, a length L2 from an outer surface (a surface facing the frame portion 1A1) 1A22b of the second protruding piece 1A22 to a side surface (a surface facing the frame portion 1A1) 212b2b of the second extension portion 212b2 in an extending direction is longer than a distance D2 between a side surface (a surface facing the second protruding piece 1A22) 212b2a of the second extension portion 212b2 and the outer surface 1A22a. According to such a structure, the flange 212b can be prevented from rotating beyond the above angle. In FIGS. 6A and 6B, only one of the pair of first protruding pieces 1A21 (the same applies to the pair of second protruding pieces 1A22) is shown, but a distance between the extension portions 212b1 and 212b2 and the other of the first protruding piece 1A21 and the second protruding piece 1A22 is the same as that in FIGS. 6A and 6B. Here, FIG. 6A is an enlarged view of the upper left corner of FIG. 5A, and FIG. 6B is an enlarged view of the lower left corner of FIG. 5A. The same configuration is applied to the upper right corner of FIG. 5A and the lower right corner of FIG. 5A.

More specifically, when the operation button is deviated in either a left or right direction on the sheet of FIG. 5A, a distance between one of the extension portions 212b1 and 212b2 and the guide rib 1A2 is shorter than a distance between the other extension portion of the extension portions 212b1 and 212b2 and the guide rib 1A2. When the operation button is deviated in either an upper or lower direction, one of the lengths L1 and L2 is longer than the other length. Accordingly, the flange 212b can be more reliably prevented from rotating beyond the above angle. In one embodiment, the length L1 and/or the length L2 may be set to be longer than the distances D1 and D2 by the clearance between the main body 212a and the opening 1C.

In the present embodiment, since the lower surface of the upper case 1A is provided with the frame portion 1A1 and the guide rib 1A2 (the pair of first protruding pieces 1A21 and the pair of second protruding pieces 1A22), the operation button 212 can be prevented from being erroneously inserted into the opening 1C in addition to a case where the operation button 212 is to be inserted in the vertically reversed orientation as shown in FIG. 5B.

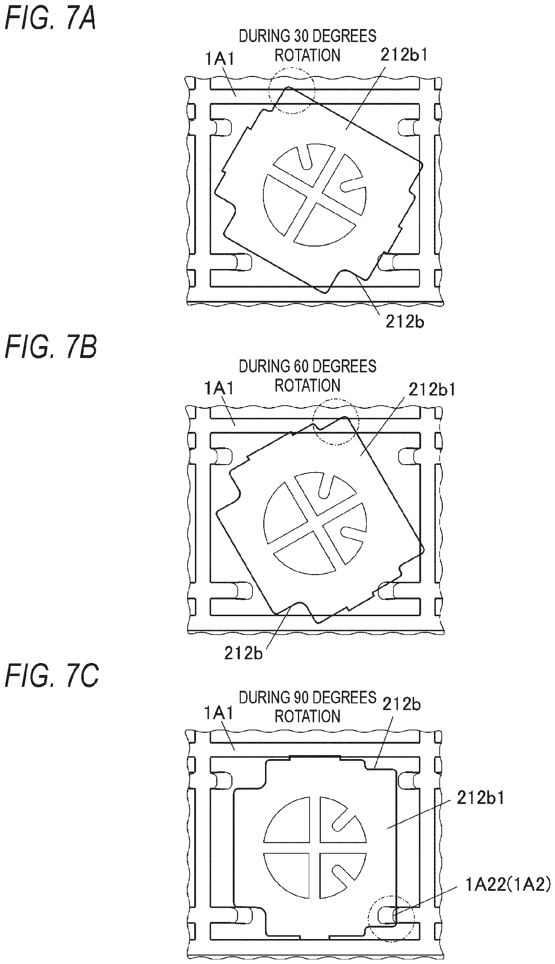

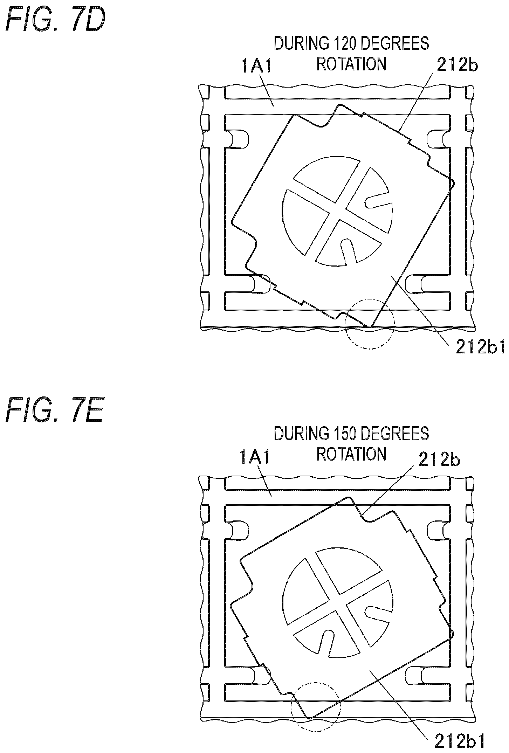

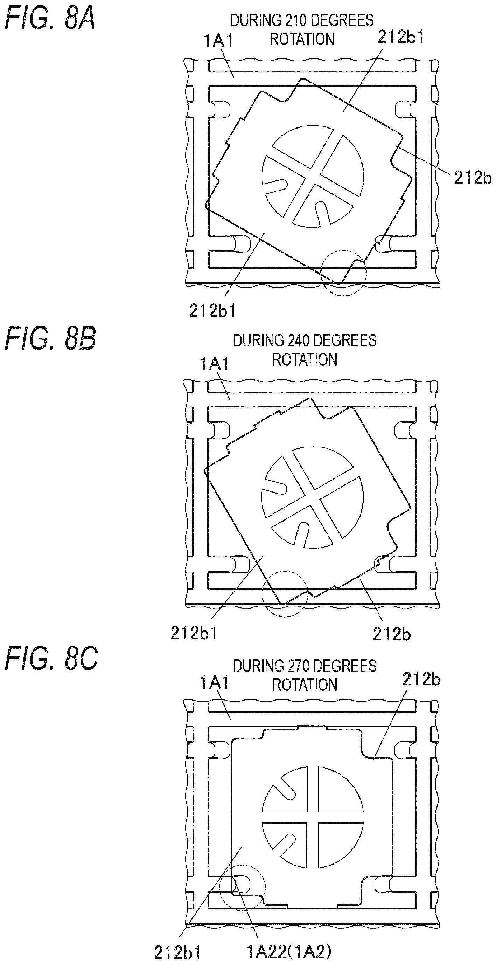

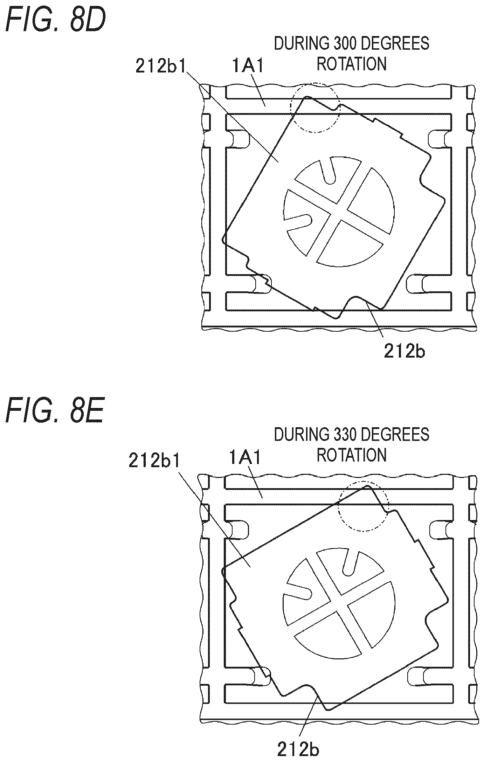

Specifically, as shown in FIGS. 7A, 7B, 7D, 7E, 8A, 8B, 8D, and 8E, for example, when the operation button 212 is to be inserted into the opening 1C in a state where the operation button 212 is rotated (rotated clockwise on the sheet) by any angle of 30 degrees, 60 degrees, 120 degrees, 150 degrees, 210 degrees, 240 degrees, 300 degrees, and 330 degrees from a correct orientation (see FIG. 5A), the length L4 of the diagonal line of the flange 212b is designed to be a predetermined length longer than the width D4 of the region R in the up-down direction (an extending direction of the flange 212b) as described above, so that the operation button 212 can be prevented from being inserted (completely inserted) into the opening 1C by engaging (overlapping) the first extension portion 212b1 of the flange 212b with the frame portion 1A1. As shown in FIGS. 7C and 8C, when the operation button 212 is to be inserted into the opening 1C in a state where the operation button 212 is rotated by any angle of 90 degrees or 270 degrees from a correct orientation (see FIG. 5A), the length L3 of the flange 212b in an extending direction (a direction orthogonal to the widths W1 and W2) is longer than the interval G2 and the width W1 is longer than the distance D3, so that the operation button 212 can be prevented from being inserted (completely inserted) into the opening 1C by engaging (overlapping) the first extension portion 212b1 of the flange 212b with the pair of second protruding pieces 1A22. More specifically, the opening 1C is formed such that, when the operation button 212 is to be inserted into the opening 1C in a state where the operation button 212 is rotated by any angle of 90 degrees or 270 degrees from a correct orientation (that is, when viewed from an insertion direction, the main body 212a is positioned inside the opening 1C and the operation button 212 is rotated by any angle of 90 degrees or 270 degrees from the correct orientation), at least a part of the second extension portion 212b1 overlaps the second protruding piece 1A22.

In the present embodiment, as described with reference to FIG. 5C, when the second extension portion 212b2 of the flange 212b engages with the pair of second protruding pieces 1A22, the flange 212b can be prevented from rotating beyond the above angle. When the first extension portion 212b 1 of the flange 212b is engaged with the pair of first protruding pieces 1A21, the flange 212b can also be prevented from rotating beyond the above angle. Therefore, by making the widths W1 and W2 of the first extension portion 212b 1 and the second extension portion 212b2 as large as possible, that is, by making a clearance (gap) between the first extension portion 212b 1 and the pair of first protruding pieces 1A21 or a clearance (gap) between the second extension portion 212b2 and the pair of second protruding pieces 1A22 as small as possible, a backlash of the operation button 212 can be further prevented.

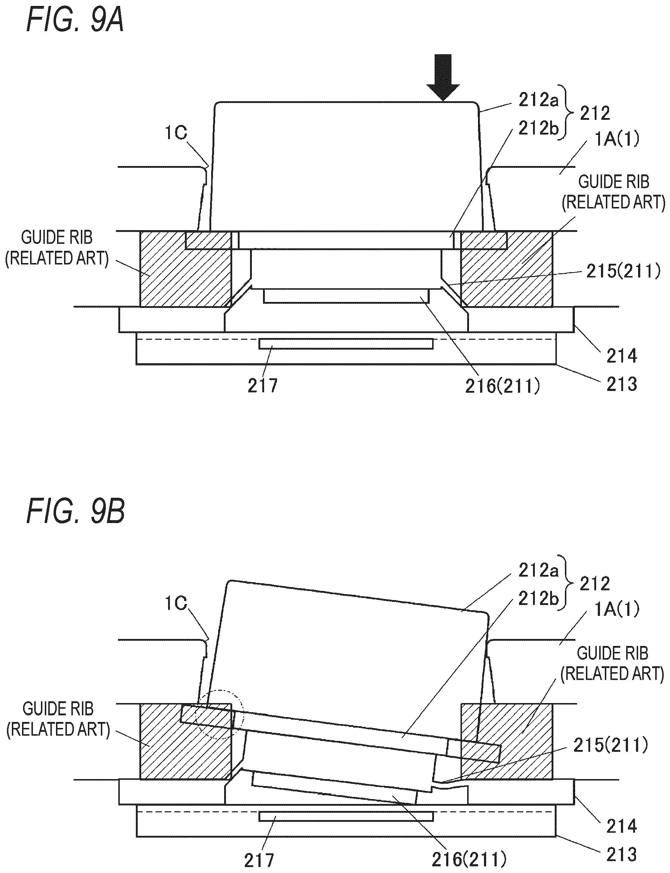

However, as shown in FIG. 9A, since a guide rib of the related art has such a shape that an outer surface (an outer surface facing the flange 212b with a gap therebetween) that can come into contact with the flange 212b is perpendicular to a lower surface of the upper case 1A, when an end of the operation button 212 is pressed to be in a so-called obliquely pressed state, as shown in FIG. 9B, a failure in which the first extension portion 212b 1 and/or the second extension portion 212b2 (the flange 212b) interferes with the guide rib and the movable contact 216 does not come into contact with (makeup) the fixed contact 217 or a failure in which the operation button 212 is not restored occurs.

Here, in the present embodiment, as shown in FIGS. 3 and 4, at least a part of the pair of first protruding pieces 1A21 and the pair of second protruding pieces 1A22 is configured such that an interval between the flange 212b and the pair of first protruding pieces 1A21 and the pair of second protruding pieces 1A22 is widened when a pressing operation is performed toward a pressing direction of the operation button 212. Specifically, outer surfaces (that is, outer surfaces facing the flange 212b, specifically, outer surfaces 1A21a disposed close to and facing the flange 212b (with an interval therebetween)) that can come into contact with the flange 212b of the pair of first protruding pieces 1A21, and outer surfaces (that is, outer surfaces facing the flange 212b, specifically, outer surfaces 1A22a disposed close to and facing the flange 212b (with a gap therebetween)) that can come into contact with the flange 212b of the pair of second protruding pieces 1A22 are provided with a gradient that moves away from the flange 212b toward the pressing direction of the operation button 212. Accordingly, even when the end of the operation button 212 is pressed to be in a so-called obliquely pressed state, as shown in FIG. 9C, it is possible to prevent the flange 212b (the second extension portion 212b2) from interfering with the guide rib 1A2 (the pair of second protruding pieces 1A22). As a result, it is possible to prevent occurrence of a failure in which the movable contact 216 does not come into contact (makeup) with the fixed contact 217 or a failure in which the operation button 212 is not restored. In the present embodiment, a taper (for example, a taper angle; 8 to 10°) widening toward the pressing direction of the operation button 212 is provided on an inner surface of the opening 1C. Accordingly, even when the end of the operation button 212 is pressed to be in a so-called obliquely pressed state, the operation button 212 is less likely to interfere with the inner surface of the opening 1C. Therefore, it is possible to more effectively prevent occurrence of a failure in which the operation button 212 is not fully pressed or a failure in which the operation button 212 cannot be restored.

Further, in the present embodiment, as shown in FIG. 1, a size of the flange 212b of the operation button 212 is made different between an upper half key group (type I; small key) and a lower half key group (type II; large key) of the input key group 2, and the gradient of the guide rib 1A2 is made different. Specifically, as shown in FIGS. 10A and 10B, for a key group of type I (a first operation button), a length (A) of the flange 212b is 8.95 ± 0.05 (mm), a notch length (B) of the flange 212b is 1.47 ± 0.05 (mm), a clearance (C) between the flange 212b and the guide rib 1A2 is 0.20 ± 0.20 (mm), and the above-described gradient (D) of the guide rib 1A2 is 20° ± 1°. On the other hand, for a key group of type II (a second operation button), a length (A) of the flange 212b is 11.00 ± 0.05 (mm), a notch length (B) of the flange 212b is 2.05 ± 0.05 (mm), a clearance (C) between the flange 212b and the guide rib 1A2 is 0.20 ± 0.20 (mm), and the above-described gradient (D) of the guide rib 1A2 is 10° ± 1°. That is, the key group of type II (the second operation button) whose length (A) of the flange 212b is longer than that of type I is designed to have the smaller gradient (D) of the guide rib 1A2. This is because an inclination of the operation button 212 when the key having the longer length (A) of the flange 212b presses the end of the operation button 212 is small.

As described above, the scientific electronic calculator 100 according to the present embodiment includes the operation button 212 having the flange 212b and the device case 1 formed with the opening 1C into which the operation button 212 is inserted. The device case 1 is provided with the guide rib 1A2 that guides reception of the flange 212b into the region R, and at least a part of the guide rib 1A2 is configured such that an interval between the flange 212b and the guide rib 1A2 is widened when the pressing operation is performed toward the pressing direction of the operation button 212. Accordingly, even when the end of the operation button 212 is pressed to be in a so-called obliquely pressed state, the flange 212b of the operation button 212 is less likely to interfere with the guide rib 1A2, so that it is possible to prevent occurrence of a failure in which the operation button 212 is not fully pressed or a failure in which the operation button 212 cannot be restored. As a result, a pressing operation of the operation button 212 can be smoothly performed.

In addition, in the guide rib 1A2 of the scientific electronic calculator 100 according to the present embodiment, at least a part of the outer surfaces 1A21a and 1A22a facing the flange 212b is provided with a gradient in which an interval between the flange 212b and the outer surfaces 1A21a and 1A22a is widened when the pressing operation is performed toward the pressing direction of the operation button 212. Accordingly, even when the end of the operation button 212 is pressed to be in a so-called obliquely pressed state, the flange 212b of the operation button 212 is less likely to interfere with the outer surfaces 1A21a and 1A22a of the guide rib 1A2. Therefore, it is possible to prevent occurrence of a failure in which the operation button 212 is not fully pressed or a failure in which the operation button 212 cannot be restored. As a result, a pressing operation of the operation button 212 can be smoothly performed.

In addition, in the scientific electronic calculator 100 according to the present embodiment, the above-described gradient is formed from one end to the other end in a thickness direction of the device case 1 on the outer surfaces 1A21a and 1A22a facing the flange 212b of the guide rib 1A2, so that the processing of the outer surfaces 1A21a and 1A22a can be facilitated.

The scientific electronic calculator 100 according to the present embodiment includes the operation button (first operation button) 212 of type I and the operation button (second operation button) 212 of type II whose flange 212b is wider than that of the operation button 212 of type I, and a gradient of the guide rib 1A2 corresponding to the operation button 212 of type II is smaller than a gradient of the guide rib 1A2 corresponding to the operation button 212 of type I. Accordingly, since the gradient of the guide rib 1A2 suitable for the operation button 212 can be given according to a size of the flange 212b of the operation button 212, it is possible to more effectively prevent interference of the operation button 212 with the inner surface of the opening 1C.

In the device case 1 of the scientific electronic calculator 100 according to the present embodiment, since the inner surface of the opening 1C of the device case 1 is provided with a taper widening toward the pressing direction of the operation button 212, even when the end of the operation button 212 is pressed to be in a so-called obliquely pressed state, the operation button 212 is less likely to interfere with the inner surface of the opening 1C. Therefore, it is possible to more effectively prevent occurrence of a failure in which the operation button 212 is not fully pressed or a failure in which the operation button 212 cannot be restored.

In addition, in the scientific electronic calculator 100 according to the present embodiment, the guide rib 1A2 is engaged with the flange 212b when the operation button 212 is rotated to an angle to prevent the operation button 212 from rotating beyond the above angle. Therefore, the guide rib 1A2 prevents the operation button 212 from rotating beyond an angle, so that the backlash of the operation button 212 can be prevented.

Since the guide rib 1A2 of the scientific electronic calculator 100 according to the present embodiment includes the pair of first protruding pieces 1A21 and the pair of second protruding pieces 1A22, and the pair of first protruding pieces 1A21 and the pair of second protruding pieces 1A22 are configured such that the surfaces facing each other are the outer surfaces 1A21a and 1A22a facing the flange 212b, even when not only one end of the operation button 212 but also the other end opposite to the one end is pressed to be in a so-called obliquely pressed state, the flange 212b of the operation button 212 is less likely to interfere with the guide rib 1A2. Therefore, it is possible to more effectively prevent occurrence of a failure in which the operation button 212 is not fully pressed or a failure in which the operation button 212 cannot be restored.

Although the embodiment of the present invention has been described above, the present invention is not limited to the embodiment, and various modifications can be made without departing from the gist thereof.

In the above embodiment, as shown in FIG. 5A, in the flange 212b of the operation button 212, the width W1 in the left-right direction of the extension portion (the first extension portion) 212b1 that extends upward on the sheet is set larger than a width W2 in the left-right direction of the extension portion (the second extension portion) 212b2 that extends downward on the sheet. Alternatively, for example, the width W1 of the extension portion (the first extension portion) 212b1 that extends upward on the sheet may be smaller than the width W2 of the extension portion (the second extension portion) 212b2 that extends downward on the sheet. In this case, the arrangement of the pair of first protruding pieces 1A21 and the pair of second protruding pieces 1A22 in the above embodiment is interchanged.

In the above embodiment, the outer surfaces 1A21a that can come into contact with the flange 212b of the pair of first protruding pieces 1A21 and the outer surfaces 1A22a that can come into contact with the flange 212b of the pair of second protruding pieces 1A22 are provided with a gradient that moves away from the flange 212b toward the pressing direction of the operation button 212. The gradient is not limited to a case where the gradient is formed from an upper end to a lower end of each outer surface (from one end to the other end in the thickness direction of the device case 1). For example, the gradient may be provided between the upper end of each of the outer surfaces 1A21a and 1A22a (a base end of the lower surface of the upper case 1A) and a predetermined height (for example, a height corresponding to a thickness of the flange 212b). Further, in one embodiment, at least a part of the first protruding piece 1A21 of any one of the pair of first protruding pieces 1A21 and at least a part of the second protruding piece 1A22 of any one of the pair of second protruding pieces 1A22 may be configured such that an interval between the flange 212b and the first protruding piece 1A21 or the second protruding piece 1A22 is widened when a pressing operation is performed toward the pressing direction of the operation button 212.

Although the embodiment of the present invention has been described above, the scope of the present invention is not limited to the above-described embodiment, and includes the scope of the invention defined by the claims and the equivalents thereof.

The present application is based on a Japanese Patent Application (JP2021-207090A) filed on December 21, 2021, and contents thereof are incorporated herein by reference.

### INDUSTRIAL APPLICABILITY

The present invention can be applied to an electronic device, such as an electronic device capable of smoothly performing a pressing operation of an operation button.

## Claims

1. An electronic device comprising:
an operation button having a flange; and
a device case formed with an opening into which the operation button is inserted,
wherein the device case is provided with a guide rib that guides reception of the flange into a region, and
wherein at least a part of the guide rib is configured such that an interval between the flange and the guide rib is widened when a pressing operation is performed toward a pressing direction of the operation button.

2. The electronic device according to claim 1,
wherein the guide rib has, on at least a part of an outer surface facing the flange, a gradient with which an interval between the flange and the outer surface is widened when the pressing operation is performed toward the pressing direction of the operation button.

3. The electronic device according to claim 2,
wherein the gradient is formed from one end to the other end in a thickness direction of the device case on the outer surface.

4. The electronic device according to claim 2,
wherein the gradient is formed only on a part of the outer surface.

5. The electronic device according to any one of claims 2 to 4, further comprising:
a plurality of the operation buttons,
wherein the plurality of operation buttons include at least a first operation button and a second operation button having a larger flange than the first operation button, and
wherein the gradient of the guide rib corresponding to the second operation button is smaller than the gradient of the guide rib corresponding to the first operation button.

6. The electronic device according to any one of claims 1 to 5,
wherein the device case is provided, on an inner surface of the opening, with a taper widening toward the pressing direction of the operation button.

7. The electronic device according to any one of claims 1 to 6,
wherein, when the operation button is rotated to an angle, the guide rib is engaged with the flange to prevent the operation button from rotating beyond the angle.

8. The electronic device according to any one of claims 2 to 7,
wherein the guide rib includes a plurality of pairs of protruding pieces, and
wherein the pair of protruding pieces are configured such that surfaces facing each other are outer surfaces facing the flange.
